# EUROPÄISCHE PATENTANMELDUNG

(11) **EP 1 594 350 A2**
(43) Veröffentlichungstag der Anmeldung: **09.11.2005**
(21) Anmeldenummer: 05009424.2
(22) Anmeldetag: 29.04.2005
(51) Int. Cl.: H05K 3/12

(54) **Applikationsverfahren für eine Bestandteile eines elektronischen Schaltkreises innerhalb einer Druckmaschine**

(30) Priorität: 03.05.2004 DE 102004021643
(71) Anmelder: MAN Roland Druckmaschinen AG, 63012 Offenbach (DE)
(72) Erfinder: Walther, Thomas, 65719 Hofheim (DE)
(74) Vertreter: Zacharias, Frank L.

(57) **Zusammenfassung**

Die vorliegende Erfindung beschreibt ein Verfahren zum Drucken eines elektronischen Schaltkreises oder Bestandteile davon innerhalb einer Druckmaschine im Schön- und Widerdruckverfahren, wobei die leitfähige Struktur auf die Schöndruckseite (Bogenrückseite) des Bedruckstoffes gedruckt wird, der Bogen anschließend umstülpt wird und auf das eigentliche, dekorative Druckmotiv auf die Widerdruckseite in einem Arbeitsdurchgang gedruckt wird. Als Alternative zu dem Schön- und Widerdruckverfahren kann der Schaltkreis oder Bestandteile eines Schaltkreises, indem dem Druckwerken für den mehrfarbigen Druck ein Druckwerk für den Druck auf die Bedruckstoffrückseite vorgeschaltet wird, so dass dieses von unten gegen den durchlaufenden Druckbogen gerichtet wird. Weiterhin beschreibt das Patent ein Verfahren zur Applikation von Chips auf einen Bedruckstoff, wobei die die Gegenseite des Druckbogens mit dem Druckmotiv durch eine Kühlvorrichtung gekühlt wird, um eine Beeinträchtigung des Druckmotives und/oder des Bedruckstoffes zu vermeiden.

## Beschreibung

Die Erfindung betrifft Verfahren nach den Oberbegriffen der Ansprüche 1, 11 und 15.

Die vorliegende Erfindung beschreibt ein Verfahren zum Drucken eines elektronischen Schaltkreises oder Bestandteile davon innerhalb einer Druckmaschine im Schön- und Widerdruckverfahren, wobei die leitfähige Struktur auf die Schöndruckseite des Bedruckstoffes gedruckt wird, der Bogen anschließend umstülpt wird und auf das eigentliche, dekorative Druckmotiv auf die Widerdruckseite in einem Arbeitsdurchgang gedruckt wird, Als Alternative zu dem Schön- und Widerdruckverfahren kann der Schaltkreis, indem dem Druckwerken für den mehrfarbigen Druck ein Druckwerk für den Druck auf die Bedruckstoffrückseite vorgeschaltet wird, so dass dieses von unten gegen den durchlaufenden Druckbogen gerichtet wird. Weiterhin beschreibt das Patent ein Verfahren zur Applikation von Chips auf einen Bedruckstoff.

Leitfähige Materialien werden oftmals im Siebdruck aufgebracht. Eine leitfähige Paste, die zum Beispiel Silber, Aluminium oder leitfähige Ruße enthalten kann, wird auf ein Substrat aufgebracht, um eine leitfähige Leiterbahn auf dem Substrat zu erzeugen. Auch sind Anwendungen bekannt, bei denen in einem lithographischen Druckverfahren ähnliche leitfähige Druckverfahren auf einen Bedruckstoff aufgetragen werden.

Eine der möglichen Anwendungen sind so genannte radio frequency identification (RFID) tags. Diese RFID tags weisen die Möglichkeit auf Informationen über ein Produkt zu speichern. Diese gespeicherten Informationen können zum Beispiel genutzt werden, Warenströme zu steuern und die Bestandsführung zu vereinfachen. Wegen der deutlich höheren Datenspeicherkapazität im Gegensatz zu der bekannten Barcodedekodierung sind für RFID tags beliebige weitere Anwendungsgebiete denkbar.

Ein RFID-Tag besteht aus einer Antenne, gegebenenfalls weiteren elektronischen Bauelementen und dem Chip, der in der Regel durch eine so genanntes Bondingverfahren appliziert wird. Die Antennen der RFID tags können heutzutage problemlos im Offsetdruck, Siebdruck oder Flexodruck aufgetragen werden, während die für die RFID tags benötigten Chips in der Regel auf die Kontaktstellen der Antenne geklebt oder gelötet werden. Zukünftig ist es jedoch auch vorstellbar, dass komplette elektronische Schaltungen auf ein Druckprodukt gedruckt werden. Die Antennen können je nach angewandtem Frequenzband als Spule oder Dipolantenne ausgebildet sein.

Die gedruckten Antennen stören aber mit dem gewünschten Design der gedruckten Verpackung, wegen des Farbtons der leitfähigen Druckfarben und der relativ hohen Schichtdicke, die für das Erreichen einer guten Leitfähigkeit von Nöten ist. Auch kann an einer Verpackung außen aufgedruckter RFID tag leicht zerstört bzw. entfernt werden. Ein weiteres Problem entsteht auch dann, wenn nachträglich in einem weiteren Arbeitsgang der Chip auf die Kontaktstelle der Antenne geklebt oder gelötet wird. Beim Klebevorgang oder Lötvorgang entstehen an den Klebestellen oftmals Temperaturen, die zur einer Verfärbung des Bedruckstoffes oder schlimmstenfalls zu Brandstellen auf dem Bedruckstoff führen. Diese Verfärbung oder Brandstellen sind schon allein wegen der Störung des dekorativen Eindrucks der Verpackung nicht erwünscht.

Erfindungsgemäß wird diese Problematik gelöst, indem Teile des Schaltkreises auf die Innenseite der Verpackung (Schöndruckseite oder Bogenrückseite des Bedruckstoffes im S&W Verfahren) gedruckt werden und der Bogen anschließend gegebenenfalls getrocknet und dann durch eine Wendeeinrichtung umstülpt wird und auf der Widerdruckseite des Bedruckstoffes in einem Arbeitsgang das graphische, dekorative Motiv gedruckt wird. Dieses Verfahren hat den Vorteil, dass das äußere Erscheinungsbild weder durch die aufgebrachten Antennen oder die beim Kleben und Löten der Chips entstehenden Brandstellen gestört wird. Es kann sinnvoll sein, dass vor dem Auftragen der leitfähigen Struktur ein Primer oder eine Druckfarbe vorgedruckt wird, damit die oftmals rauere Bedruckstoffrückseite durch den Primer / Druckfarbenauftrag geschlossener wird und die leitfähige Druckfarbe nicht zu stark in den Bedruckstoff wegschlägt.

Der Auftrag vor der Wendeeinrichtung kann durch ein oder mehrere Flexodruckwerke oder durch eine oder mehrere Offsetdruckwerke erfolgen. Eine Kombination des Drucks von leitfähigen Strukturen mit dem Druck eines dekorativen Motivs ist ebenso denkbar. Als Alternative zu dem direkten Drucken einer leitfähigen Druckfarbe kann ein Folientransferverfahren eingesetzt werden. Dabei wird das Motiv der leitfähigen Struktur mit einem Kleber vorgedruckt. Die an den Motivstellen mit dem Kleber versehene Bedruckstoffrückseite wird dann in einem weiteren Arbeitsschritt mit einer Transferfolie in Kontakt gebracht, deren Transferschicht aus einem leitfähigen Material besteht. An den Stellen auf der Bedruckstoffrückseite, die mit dem Kleber versehen ist, geht diese leitfähige Transferschicht auf die mit Kleber versehenen Motivstellen über. Bei den Folientransferverfahren gibt es zwei unterschiedliche Verfahren, die zur Anwendung kommen. Diese Verfahren unterscheiden sich in den eingesetzten Klebertypen. Einmal kann ein physikalisch trocknender Kleber eingesetzt werden oder alternativ ein Kleber, der unter UV Strahlungseinwirkung aushärtet.

Entsprechende ausgebildete Bogenoffsetdruckmaschinen mit mehreren Druckwerken in Reihenbauart für die Herstellung mehrfarbiger Drucke im Schöndruck und im Schön- und Widerdruck sind aus den Druckschriften DE 34 19 762 und DE 37 17 093 bekannt. In der DE 40 36 253 wird eine Druckmaschine offenbart, die eine Wendeeinrichtung nach einem vorgeschaltetem Veredelungswerk aufweist. Entsprechende Wendeeinrichtungen sind daher schon in vielfältigen Ausprägungen bekannt.

Auch sind so genannte Widerdruckwerke bekannt, die von unten angeordnet die Bogenrückseite ohne Umstülp- / Wendevorgang zu bedrucken. Eine solche Vorrichtung ist zum Beispiel in der DE 29914812 offenbart. Das Schön- und Widerdruckverfahren und das Widerdruckverfahren können im Sinne der Erfindung genutzt werden.

Ein weiterer Vorteil die leitfähigen Strukturen auf die Bedruckstoffrückseite zu drucken liegt darin, dass die leitfähigen Strukturen während des Durchgangs durch die Folgedruckwerke durch den Gegendruckzylinder geglättet bzw. kalandriert werden. Versuche haben gezeigt, dass durch die Kalandration / Glättung die Leitfähigkeit der leitfähigen Strukturen deutlich gesteigert werden kann. Eine weitere Steigerung der Leitfähigkeit ließe sich erzielen, indem die Gegendruckzylinder, die mit der Bogenrückseite samt der aufgedruckten leitfähigen Struktur in Kontakt kommen, leicht temperiert werden. Ein optimaler Wärmeübergang ist durch den Druck und engen Kontakt gegeben. Schon eine Erhöhung der Temperatur auf eine Temperatur > 35 Grad erbrachte ein schnelleres Ansteigen der Leitfähigkeit nach dem Druck.

Eine weitere Herausforderung besteht in dem Bonding / Kleben / Löten der Chips auf die Kontaktstellen der Antennen oder anderer leitfähigen Strukturen auf der Rückseite des Bedruckstoffes. Die Hitze kann von der Rückseite des Bedruckstoffes während des Fixierungsprozess des Chips auf die bedruckte Vorderseite des Bedruckstoffes durchschlagen und dort zu Verfärbungen des Druckbildes führen. Diese Verfärbungen können verhindert werden, wenn die bedruckte Bedruckstoffvorderseite während des Fixierungsprozesses des Chips gekühlt wird. Die Kühlung kann während des Fixierungsprozesses des Chips durch Luft, indem die bedruckte Vorderseite des Bedruckstoffes gegen eine gekühlte Platte gedrückt wird oder durch einen anders gearteten Kühlprozess erfolgen. Eine solche Kühlung wäre deutlich aufwendiger zu realisieren, wenn die leitfähige Struktur / Antenne auf die Bogenvorderseite mit dem dekorativen Druckmotiv gedruckt würde. Verbrennungen und Verfärbungen wären dann zu erwarten.

## Patentansprüche

1. Druckverfahren,
**gekennzeichnet dadurch,**
**dass** auf der Bedruckstoffrückseite mindestens eine leitfähige Struktur aufgedruckt wird, die später in einem weiteren Arbeitsgang mit einem Chip verbunden wird und anschließend die Bedruckstoffvorderseite, mindestens zu einem Teil im Offsetdruckverfahren, in einem Arbeitsgang mit einem dekorativem Bildmotiv bedruckt wird,

2. Druckverfahren nach Anspruch 1,
**gekennzeichnet dadurch,**
**dass** zwischen dem Bedrucken der Rück- und der Vorderseite ein Umstülp- /Wendevorgang durch eine Umstülp- / Wendeinrichtung erfolgt.

3. Druckverfahren nach Anspruch 1,
**gekennzeichnet dadurch,**
**dass** die Bogenrückseite mit der leitfähigen Struktur durch eine Widerdruckwerk bedruckt wird.

4. Druckverfahren nach Anspruch 1 und 2 oder 3,
**gekennzeichnet dadurch,**
**dass** der Druck der leitfähigen Strukturen mittels mindestens eines Hochdruck/ Flexodruckwerkes auf die Bedruckstoffrückseite erfolgt.

5. Druckverfahren nach Anspruch 1 und 2 oder 3,
**gekennzeichnet dadurch,**
**dass** der Druck der leitfähigen Strukturen mittels mindestens eines Offsetdruckwerkes auf die Bedruckstoffrückseite erfolgt.

6. Druckverfahren nach Anspruch 1 und Anspruch 4 oder Anspruch 5,
**gekennzeichnet dadurch,**
**dass** vor dem Auftragen der leitfähigen Struktur die Bedruckstoffoberfläche durch eine vorgedruckten Primer oder Druckfarbe zu mindesten zu einem Teil geschlossen wird.

7. Druckverfahren nach Anspruch 1-6,
**gekennzeichnet dadurch,**
**dass** nach dem Druck der leitfähigen Struktur auf die Bedruckstoffrückseite eine Trockeneinrichtung folgt, die auf die Bedruckstoffrückseite zusammen mit der aufgedruckten leitfähigen Struktur einwirkt,

8. Verfahren nach Anspruch 1-6,
**gekennzeichnet dadurch,**
**dass** zu mindestens ein Gegendruckzylinder der Nachfolgedruckwerke, die der Bedruckstoffrückseite mit der aufgedruckten leitfähigen Struktur zugewandt sind, auf eine Temperatur > 35 Grad Celsius temperiert sind.

9. Druckverfahren nach Anspruch 1,
**gekennzeichnet dadurch,**
**dass** es sich beim dem Bedruckstoff um ein Papier oder einen Karton handelt.

10. Druckverfahren nach Anspruch 1,
**gekennzeichnet dadurch,**
**dass** es sich bei dem Bedruckstoff um eine Folie handelt.

11. Druckverfahren,
**gekennzeichnet dadurch,**
**dass** auf der Bedruckstoffrückseite zu mindestens eine leitfähige Struktur durch ein Folientransferverfahren übertragen wird, wobei zu mindestens in einem Druckwerk auf die Bedruckstoff ein Klebstoff aufgetragen wird und anschließend der Bedruckstoffrückseite eine Transferfolie zugeführt wird. An den Stellen an denen der Kleber auf die Bedruckstoffrückseite übertragen wurde wird die leitfähige Schicht von der Transferfolie auf den Bedruckstoff transferiert.

12. Verfahren nach Anspruch 11,
**gekennzeichnet dadurch,**
**dass** es sich bei dem Bedruckstoff um ein Papier handelt.

13. Verfahren nach Anspruch 11,
**gekennzeichnet dadurch,**
**dass** es sich bei dem Bedruckstoff um einen Karton handelt.

14. Verfahren nach Anspruch 11,
**gekennzeichnet dadurch,**
**dass** es sich bei dem Bedruckstoff um eine Folie handelt.

15. Verfahren zur Applikation eines Chips auf eine gedruckte leitfähige Struktur,
**gekennzeichnet dadurch,**
**dass** während des Applikationsvorgangs des Chips die mit dem Druckmotiv versehene Bedruckstoffvorderseite gekühlt wird.

16. Verfahren nach Anspruch 15,
**gekennzeichnet dadurch,**
**dass** die Kühlung der bedruckten Bedruckstoffvorderseite erreicht wird, indem diese während der Applikationsvorgangs gegen eine gekühlte Platte gedrückt wird.

17. Verfahren nach Anspruch 15,
**gekennzeichnet dadurch,**
**dass** die Kühlung der bedruckten Bedruckstoffvorderseite durch Lufteinwirkung erzielt wird.

18. Verfahren nach Anspruch 12,
**gekennzeichnet dadurch,**
**dass** es sich bei dem Bedruckstoff um ein Papier handelt.

19. Verfahren nach Anspruch 12,
**gekennzeichnet dadurch,**
**dass** es sich bei dem Bedruckstoff um ein Papier handelt.
